## Europäisches Patentamt

## European Patent Office

## Office européen des brevets

(11) Publication number: **0 133 023**
**B1**

(12) **EUROPEAN PATENT SPECIFICATION**

(45) Date of publication of patent specification: **13.06.90**

(21) Application number: **84305083.2**

(22) Date of filing: **26.07.84**

(51) Int. Cl.⁵: **H 01 L 27/10,** H 01 L 23/52 //
G11C17/00

(54) **Read-only memory.**

(30) Priority: **29.07.83 JP 137537/83**

(43) Date of publication of application:
**13.02.85 Bulletin 85/07**

(45) Publication of the grant of the patent:
**13.06.90 Bulletin 90/24**

(84) Designated Contracting States:
**DE FR GB IT**

(56) References cited:
**EP-A-0 024 311**
**EP-A-0 054 102**
**EP-A-0 087 979**
**US-A-4 074 238**
**US-A-4 255 210**
**US-A-4 358 889**
**US-A-4 380 866**

**PATENTS ABSTRACTS OF JAPAN, vol. 6, no. 32**
**(E-96) 910r, 26th February 1982, no. 56 150 858**
**(HITACHI SEISAKUSHO K.K.) 21-11-1981**

(73) Proprietor: **HITACHI, LTD.**
**6, Kanda Surugadai 4-chome Chiyoda-ku**
**Tokyo (JP)**

(72) Inventor: **Sakai, Yoshio**
**1-47-2-E304, Akatsuki-cho**
**Hachioji-shi Tokyo (JP)**
Inventor: **Nagai, Ryo**
**5-18-30, Midori-cho**
**Kaganei-shi Tokyo (JP)**
Inventor: **Yamamoto, Shuichi**
**3-1-3, Higashi-Koigakubo**
**Kokubunji-shi Tokyo (JP)**
Inventor: **Nakamura, Hideo**
**2196-287, Hirai Hinodemachi**
**Nishitama-gun Tokyo (JP)**
Inventor: **Noguchi, Kouki**
**4-14-6, Nishi-Koigakubo**
**Kokubunji-shi Tokyo (JP)**

(74) Representative: **Calderbank, Thomas Roger**
**et al**
**MEWBURN ELLIS & CO. 2/3 Cursitor Street**
**London EC4A 1BQ (GB)**

Courier Press, Leamington Spa, England.

## Description

1. The present invention relates to the structure of a read-only-memory (hereinafter referred to as a ROM).

In a ROM in which data are stored by signals in insulated gate field effect transistors (hereinafter referred to as MOS transistors, referring to the case where an oxide film is used as an insulator), a single MOS transistor corresponds to one bit of memory. Therefore, the number of elements per bit can be reduced, as compared with various other memories, so that it is possible to manufacture the device in a highly integrated form. Furthermore, the orderly layout of the device enables design effort for large scale integration (LSI) to be reduced. Therefore, the ROM is frequently used in the logic circuitry of highly integrated microcomputers. LSI can be achieved in a highly densely integrated form, thereby permitting high-speed operation, if the memory cell area constituting the bits of the ROM is reduced, if parasitic capacitance is reduced, and if parasitic resistance is reduced.

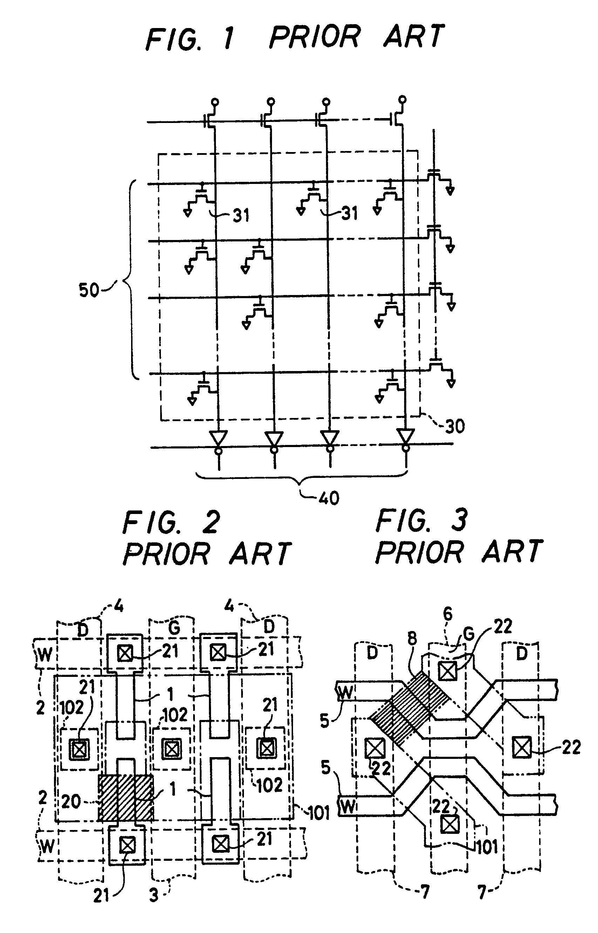

Fig. 1 of the accompanying drawings shows the circuit structure of a major portion of a standard ROM, having a memory cell array 30, memory cells 31 consisting of MOS elements selectively formed using a mask pattern, data lines 40, and word lines 50.

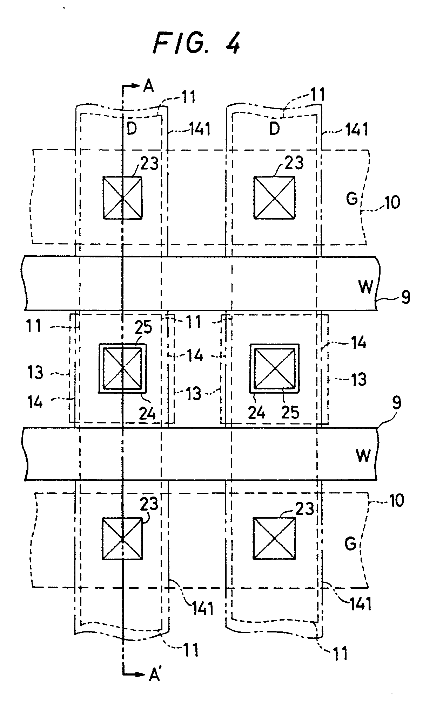

Figs. 2 and 3 of the accompanying drawings are plan views showing the structures of conventional ROM memory cells. Each of these figures shows a memory cell having four bits. In the conventional structure of Fig. 2, the MOS transistors have gate electrodes 1 consisting of polycrystalline silicon which are connected together by aluminium lines of a first metal layer running in a horizontal direction in the figure, which lines constitute word lines 2. Diffusion layers are connected together by aluminium lines of a second metal layer running in a vertical direction, in the figure which lines constitute ground lines 3 and data lines 4. The words 'horizontal' and 'vertical' are used herein merely for ease of description; the device may be in any orientation. Depending on the information stored in the bit of the memory a thin oxide region either is or is not formed under the gate electrode 1 as reprsented by a hatched region 20 in Fig. 2. This is accomplished by changing the photomask of an isolation region 101 (usually by using local oxidation of silicon (LOCOS)). In a ROM, the word lines and data lines are usually formed by aluminium lines having a small wiring resistance. Therefore, the delay time of any interconnection line, given by the product of the parasitic capacitance and the parasitic resistance, is small, and operation can occur at high speeds. However, presence of as many as five contact holes 21 in the memory of four bits makes it difficult to reduce the area of the memory cells and, hence makes it difficult to increase the density of integration.

With the structure shown in Fig. 3, however, gate electrodes of the transistors run in the horizontal direction in the figure to form word lines 5. Further, ground lines 6 and data lines 7 are formed by aluminium lines of a first metal layer running in the vertical direction in the figure. With the memory structure of Fig. 3, a thin oxide film either is or is not formed on a region 8 indicated by hatched lines to write information into the memory cell.

A thick insulator is formed (as for the isolation region) under the gate electrode (word line 5) in the right lower portion of Fig. 3, and information has already been written into the cell.

The structure of Fig. 3 has been disclosed in IEEE J. of SC "A 256 Kbit ROM with Serial ROM cell Structure", Roger Cuppens and L. H. M. Sevat, June, 1983, Vol. SC-18, No. 3.

In the memory cell shown in Fig. 3, the number of contact holes 22 is as small as three for a memory of four bits, and the memory cell area can be reduced compared with that of the structure of Fig. 2. However, since three aluminium layers (one ground line and two data lines) are running in the vertical direction, a limitation is imposed on further reduction of the area of the memory cell.

With the structure of Fig. 3, furthermore, the word lines are not straight and are long; i.e. the word lines have increased resistance and increased parasitic capacitance. Therefore, the structure of Fig. 3 is not advantageous for operating the ROM at high speed.

US—A—4255210 shows an example of a read-only memory (ROM) discussed above which employs insulated gate field effect transistors comprising word lines extending linearly over a semiconductor substrate, ground lines, and data lines, the data lines intersecting, in plan view, the word lines. Furthermore, in US—A—4255210 a common source region is provided which extend substantially parallel to the word lines. That common source region is connected to a ground line and thus may be considered part of the ground line even though the terminology in US—A—4255210 is different.

The present invention, in a first aspect seeks to achieve a high density of integration and proposes that the ground lines comprise metal of the first metal layer, and the data lines comprise metal of the second metal layer. The linearity of the word lines minimises the parasitic capacitance and parasitic resistance, and the fact that the ground lines are parallel to the word lines permits a more compact geometrical arrangement.

According to a second aspect of the present invention, it is provided that the ground lines comprise a first part and as second part, the first part being a semiconductor impurity region extending substantially parallel to the word lines, and the second part comprising metal of the first metal layer and extending substantially parallel to the data lines, and that the second metal layer is provided over the word lines through an insulator and electrically connected to the word line.

The data lines preferably intersect the word lines approximately at right angles, and may be formed from the same metal layer as the ground lines, or the word and ground lines may be formed from the same metal layer.

The ground lines are located in the gaps between the word lines, but it is not necessary that they are provided in every such gap; in most arrangements it is preferable that they are provided in alternate gaps.

The substrate, on which the word, ground, and data lines are formed, will normally have impurity regions in it, which impurity regions form the sources and drains of the insulated gate field effect transistors of the ROM. The drains are connected to the data lines either directly or via pads, and the ground lines are connected to the sources. The word lines then overlie the gates of the transistors.

Embodiments of the present invention will now be described, by way of example, with reference to the accompanying drawings, in which:

Fig. 1 is a circuit diagram of a conventional ROM and has already been discussed;

Fig. 2 is a plan view of a conventional ROM and has already been discussed;

Fig. 3 is a plan view of another conventional ROM and has already been discussed;

Fig. 4 is a plan view of a ROM according to a first embodiment of the present invention;

Fig. 5 is a sectional view of the ROM of the first embodiment, along the line A—A in Fig. 4;

Fig. 6 is a plan view showing a pattern for writing information into a ROM according to the present invention;

Fig. 7 is a plan view showing another pattern for writing information into a ROM according to the present invention;

Fig. 8 is a plan view of a ROM according to a second embodiment of the present invention;

Fig. 9 is a sectional view along the line B—B' in Fig. 8;

Fig. 10 is a sectional view along the line C—C' in Fig. 8; and

Fig. 11 is a sectional view along the line E—E' in Fig. 8.

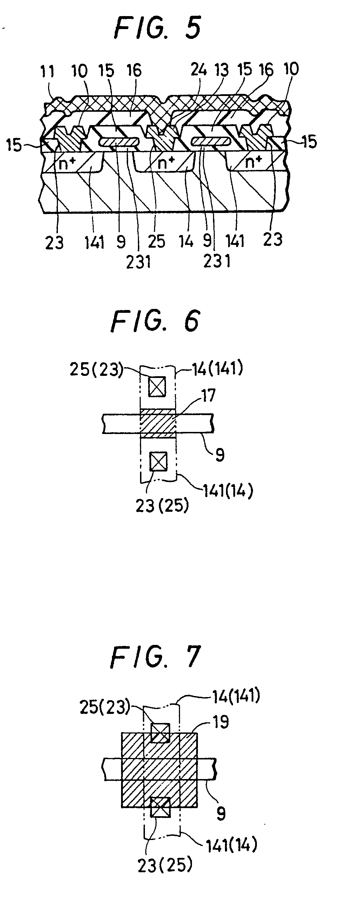

Fig. 4 is a plan view of a memory of four bits according to a first embodiment of the present invention, and Fig. 5 is a section view along the line A—A' of Fig. 4.

Word lines 9, consisting of doped polycrystalline silicon or of a metal having a small resistance, are arranged linearly in the horizontal direction in the figure. Furthermore, ground lines 10 consisting of aluminium of a first metal layer are provided in parallel with the word lines 9 in every other gap formed between the word lines 9. The ground lines 10 are connected via contact holes 23 to $n^+$-type diffusion layers 141 indicated by a dot-dash line in Fig. 4. Each diffusion layer 141 serves as a source region of an MOS transistor consituting the memory cell. A data line 11, indicated by a broken line in Fig. 4, is connected to a pad 13 consisting of aluminium of the first metal layer via a contact hole 24. The data line 11 is formed by aluminium of a second metal layer.

The pad 13 is not the one usually provided in LSI devices to make connection to the external unit, i.e., to effect wire bonding. Instead, the pad 13 connects the data line 11 to the $n^+$-type diffusion layer 14 through the contact hole 25. The $n^+$-type diffusion layer 14 acts as a common drain region for the two transistors that constitute adjacent memory cells, respectively. As shown in Fig. 5, furthermore, insulation films 15, 16 are interposed between the word lines, data lines and ground lines.

The insulation films 15 may be composed of $SiO_2$ formed by thermally oxidizing a silicon substrate and/or polycrystalline silicon.

Alternatively, the insulation films 15, 16 may be composed of $SiO_2$ that is formed by the chemical vapor deposition CVD method or may be composed of other insulation films. It is convenient to form the insulation film 16 by the CVD method.

The insulation films 15, 16 obtained by the above-mentioned methods are formed into desired shapes by a lithographic technique.

Information is written into the memory cell by forming the insulator 231 thickly or thinly as appropriate.

Although Figs. 4 and 5 illustrate only two word lines 9, additional word lines will normally be provided on the upper and lower sides of Fig. 4 to form MOS transistors that themselves form memory cells. Therefore, the $n^+$-type diffusion layer 141 serves as a common source region for the MOS transistors. Thus, the structure shown in Fig. 4 repeats itself in the upper, lower, right and left directions to form a ROM which has a highly densely integrated form.

According to the present invention, the word lines 9 are not folded but run linearly in the horizontal direction, so that the length thereof is minimized. Therefore, the word lines have reduced parasitic resistance and reduced parasitic capacitance (and in particular the parasitic capacitance between the silicon substrate and the word lines is reduced), and the ROM may operate at high speeds. The delay time of the word lines may be reduced significantly, to enable a ROM that operates at very high speeds to be fabricated, if the word lines 9 are made of a metal having a small resistivity, such as tungsten (W), molybdenum (Mo), titanium (Ti), tantalum (Ta), or a silicide of these metals, or if the word lines 9 are composed of such metals or silicides thereof formed on the polycrystalline silicon. This is because, these materials have very small resistivites.

The ground lines 10 are composed of metal lines of the first metal layer such as aluminium (Al) lines or tungsten (W) lines that run in the horizontal direction parallel to the word lines.

The structure of such ground lines is altogether different from the structures shown in Figs. 2 and 3. As will be mentioned later, the number of metal lines running in the vertical direction of the memory cell is two, which is smaller than the three metal lines of Fig. 3. Therefore, the lateral size of the ROM cell is greatly reduced, making it possible to fabricate the ROM cell in a highly integrated form. In the ROM cells of the present invention, furthermore, the individual patterns intersect substantially at right angles in the plane shown in Fig. 4, and the device can be designed so that its minimum size is determined by the processing technique. Therefore, the area of the ROM cell according to the present invention can be reduced, as compared with that of a ROM cell having a known structure prepared by the same process level, i.e. reduced by about one-half of that of the structure of Fig. 2, and reduced to about one-fifth of that of the structure of Fig. 3. In the ROM cell of the present invention it is also possible to reduce the area of the drain diffusion layer of each transistor compared with that of the structures shown in Figs. 2 and 3, and the junction capacitance of the diffusion layer, which produces about one-half the parasitic capacitance of the data line, also reduces, contributing to an increase in the speed of operation of the cell.

In the embodiment of the present invention shown in Figs. 4 and 5, the second aluminium layer which serves as the data line is connected to the diffusion layer 14 via the first aluminium layer. By forming the data line 11 using a metal line of the second aluminium layer, the insulation films 15, 16 under the data line 11 may have thicknesses greater than they could have when the data line is formed from the metal line of the first aluminium layer. Therefore, the distance between the data line and the substrate or the word line increases, and the parasitic capacitance of the data line decreases, also contributing to the increase in the operation speed of ROM cells.

The data line 11 and the $n^+$-type diffusion layer 141 may be connected together without necessarily providing the pad 13 by use of the first aluminium layer. In such an arrangement the data line 11 (which is formed from a line of the second aluminium layer) may be directly connected to the $n^+$-type diffusion layer 141 by forming a contact hole that penetrates through the insulation films 15 and 16. Even in such an arrangement, the parasitic capacitance of the data line may be decreased, as compared with conventional structures. Of course, the material for forming the ground lines 10, the data lines 11 and the pads 13 need not necessarily be aluminium. Other suitable material include e.g. tungsten (W), and molybdenum (Mo).

Memory information can be written into the ROM cell of the present invention by forming an oxide film 231 under the word line 9 by using a mask pattern 17 in the hatched portion as shown in Fig. 6, i.e., by changing the threshold voltage of the MOS transistor. The information recorded depends on the thickness of the oxide film 231.

Alternatively as shown in Fig. 7, memory information may be written into the cell by implanting impurities using a mask pattern 19 in the hatched portion.

In either case, what is important is that the change of threshold voltage should help determine the presence or absence of information.

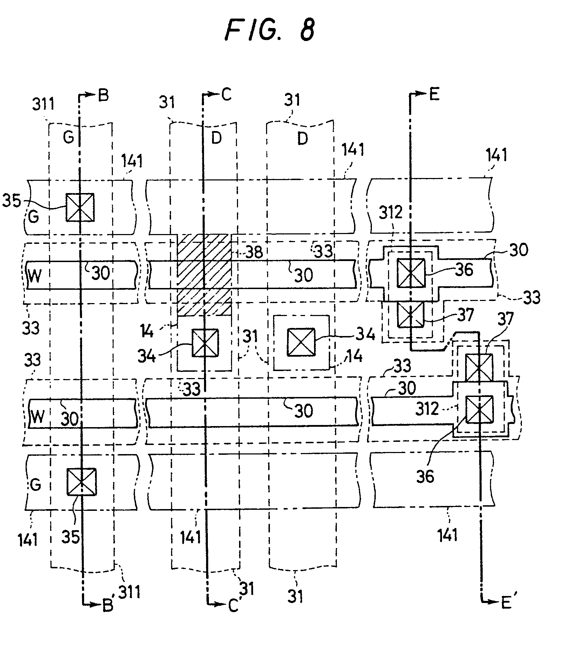

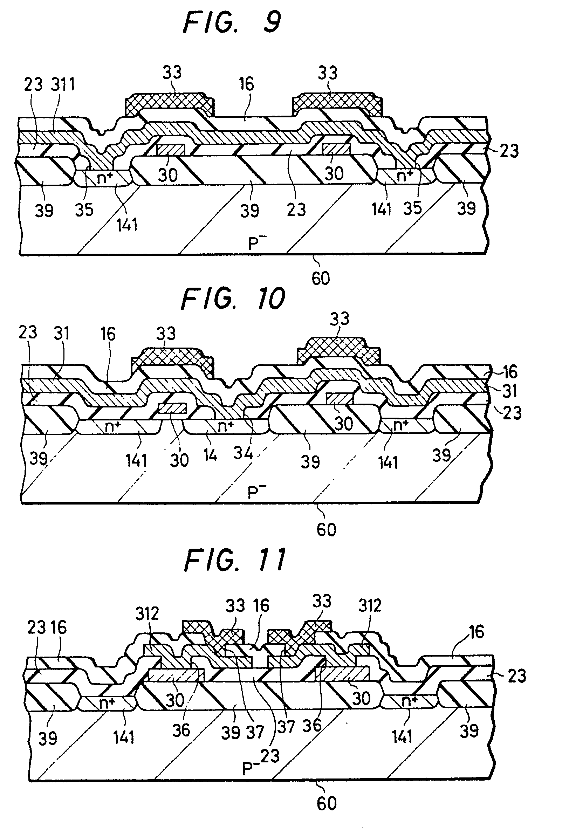

Fig. 8 is a plan view of a memory of four bits according to a second embodiment of the present invention, and Figs. 9, 10 and 11 are sectional views along the line B—B', line C—C' and line E—E' thereof, respectively.

In Fig. 8, there are shown electrically conductive lines 30 which consist of polycrystalline silicon, a silicide, or any other metal, and which form word lines, electrically conductive lines 31 which consist of aluminium or any other metal and which form data lines, electrically conductive lines 311 which are part of the same metal layer as the conductive lines 31 and which form a part of the ground lines. Intermediate layers 312 connect the word lines 30 to metal lines 33 which are located above the word lines 30 and are connected thereto via contact holes 36, 37. The ground lines also include diffusion layers 141 which diffusion layers 141 are connected to the metal ground lines 311 via contact holes 35. Other diffusion layers 14 serve as source or drain regions and are connected to data lines 31 via contact holes 34. Also shown in Figs. 9 to 11 are a silicon dioxide layer forming an isolation region 39, and the substrate 60 of the device.

This second embodiment differs from the first embodiment in the following respects:

1) In the first embodiment, the ground lines consist of metal lines 10 of the first metal layer running in the horizontal direction. In the second embodiment, the ground lines of the memory cells of a given number of bits are formed by diffusion layers 141, and are connected, via contact holes 35, to metal lines 31 of the first metal layer running in the vertical direction at ends (portions B—B' in Fig. 8) of memory cells of a given number of bits.

2) In the first embodiment, the data lines are composed of metal lines 11 of the second metal layer. In the second embodiment, the data lines are formed by metal lines 31 of the first metal layer connected, via contact holes 34, to the diffusion layers 14. Metal lines 31, 311 form data lines D and ground lines G respectively.

3) In the first embodiment, the word lines consist of single layers 9 forming gate electrodes, the layers being composed of polycrystalline silicon or tungsten, and run in the horizontal direction in Fig. 4. In the second embodiment, the word lines have a double-layer structure consisting of word lines 30 and metal lines 33 composed of aluminium of the second layer running in parallel with the word lines 30. As for the ground lines, the gate electrodes 30 and the metal line 33 of the second layer are connected together via contact holes 36, 37 at the ends of memory cells of a given number of bits, such that resistance of the word lines may be decreased.

Other features of the second embodiment will now be described in detail. First, the contact holes 34, 35, 36 under the metal lines of the first layer are formed separate from the contact holes 37 under the metal lines of the second layer on a plane. This gives an advantage in the manufacturing process as it makes it easier to applying a coating to the metal films in their portions within the contact holes. In the first embodiment, the two contact holes 24, 25 are superposed. Therefore, a large step exists in the portions of contact holes, and a difficulty exists in regard to forming the metal film. As described already, however, the layout of contact holes of the first embodiment gives advantage with regard to increasing the integration density.

Another feature of the second embodiment is that the word lines 30 are short-circuited by metal lines 33 made of aluminium, tungsten, or molybdenum having very small resistivity, giving an advantage if it is desired to operate the cell at high speeds. As shown in the sections C—C' of Fig. 8, however, an additional area is required to connect the gate electrode 30 to the metal line 33 of the second layer, presenting a slight disadvantage from the standpoint of integration density as compared with the first embodiment.

In the second embodiment as described above, the data lines and the word lines are formed linearly, and intersect each other at right angles based upon the fundamental idea mentioned in the first embodiment. The second embodiment offers improvements with regard to high-speed operation and manufacturing process, but slightly sacrifices the integration density. In this second embodiment, memory information is written into the ROM cells in the same manner as the first embodiment. In Fig. 8, the thickness of the oxide film is reduced under the word line 30 using a mask pattern in the hatched portion 38, and the threshold voltage of the MOS transistor is decreased to write memory information into the cell. The fundamental idea of the present invention can also be maintained even if the metal lines of the first layer and the metal lines of the second layer are used in a reversed manner in the second embodiment. The resistance of the diffusion layers 141 which form part of the ground lines may be further reduced by forming silicides of W, Mo, Ti, Ta etc. or refractory metals such as W, Mo etc. on the diffusion layers.

As described above, the present invention makes if possible to achieve highly integrated memory cells for a ROM, which cells require an area which is reduced to one-half to one-fifth that of the conventional structures. Furthermore, according to the present invention, parasitic resistance and parasitic capacitance of the word lines and data lines may be decreased, enabling the ROM to operate at high speeds.

The invention is not limited to the embodiments discussed above. For instance, the memory cells for ROM of the present invention may be made up of either n-channel MOS transistors or p-channel MOS transistors using a silicon semiconductor. Compound semi-conductors can also be used such as SOS (silicon on sapphire), SOI (silicon on insulation), GaAs, and the like. Also, although the foregoing description has dealt with the case in which the invention was adapted to a ROM, a structure according to the present invention may also be adapted to a programmable logic (PLA).

## Claims

1. A semiconductor read-only memory which employs insulated gate field effect transistors (31), comprising word lines (9) extending linearly over a semiconductor substrate, ground lines (10), and data lines (11), the data lines (11) intersecting, in plan view, the word lines (9); wherein the ground lines (10) are substantially parallel to the word lines, characterized in that:
the read-only memory has cells including a first and a second metal layer, the first metal layer being closer to the substrate than the second metal layer;
the ground lines (10) comprise of the first metal layer, and that the data lines (11) comprise metal of the second metal layer.

2. A semiconductor read-only memory which employs insulated gate field effect transistors (31), comprising word lines (30) extending linearly over a semiconductor substrate, ground lines (141), and data lines (31), the data lines (31) intersecting, in plan view, the word lines (30); characterized in that:
the read-only memory has cells including a first and a second metal layer, the first metal layer being closer to the substrate than the second metal layer;
the ground lines comprise a first part and a second part, the first part being a semiconductor impurity region (141) extending substantially parallel to the word lines (30), and the second part comprising metal of the first metal layer and extending substantially parallel to the data lines, and that the second metal layer (33) is provided over the word lines (30) through an insulator (23, 16) and electrically connected to the word lines (30).

3. A memory according to claim 1 or claim 2, wherein the word lines (9, 30) and the data lines (11, 31) are substantially perpendicular.

4. A memory according to any one of claims 1 to 3, wherein ground lines (10, 311, 141) are provided in alternate gaps between the word lines (9).

5. A memory according to any one of the preceding claims, having first and second impurity regions (14, 141) alternately in the semiconductor substrate, the data lines (11) being connected to the first impurity regions (14) and the ground lines (10) being connected to the second impurity regions (141).

6. A memory according to claim 5, wherein the second impurity regions (14) are parallel to the word lines (9).

7. A memory according to claim 5 or claim 6, wherein the first impurity layers (14) and the data lines (11) are connected together by pads of a metal layer, the metal layer also including the ground lines (10).

8. A memory according to claim 5 or claim 6, wherein the first impurity layers (14) and the data lines (11) are directly connected together.

9. A memory according to any one of claims 1 to 4, having first and second impurity regions (14, (41) alternately in the semiconductor substrate, the data lines being connected to the first impurity regions (14), the ground lines being formed by the second impurity regions (141).

10. A memory according to any one of the preceding claims, further including metal lines (33) separated from the word lines (30) by insulator except at two or more points at which points the metal lines (33) and the word lines (30) are connected together.

11. A memory according to claim 10, wherein the word lines (30) and the metal lines (33) are connected together by further metal lines (312), the further metal lines (312) being part of the same metal layer as the data lines (31).

12. A microcomputer employing a read-memory according to any one of the preceding claims.

**Patentansprüche**

1. Halbleiterfestspeicher, der Isolierschicht-Feldeffekt-Transistoren (31) verwendet, mit Wortleitungen (9), die linear über ein Halbleitersubstrat verlaufen, Masseleitungen (10) und Datenleitungen (11), wobei die Datenleitungen (11) in Draufsicht die Wortleitungen (9) schneiden, bei welchem die Masseleitungen (10) im wesentlichen parallel zu den Wortleitungen sind, dadurch gekennzeichnet,

daß der Festspeicher Zellen aufweist mit einer ersten und einer zweiten Metallschicht, wobei die erste Metallschicht dem Substrat näher als die zweite Metallschicht ist,

daß die Masseleitungen (10) Metall der ersten Metallschicht aufweisen, und

daß die Datenleitungen (11) Metall der zweiten Metallschicht aufweisen.

2. Halbleiterfestspeicher, der Isolierschicht-Feldeffekt-Transistoren (31) verwendet, mit Wortleitungen (30), die linear über ein Halbleitersubstrat verlaufen, Masseleitungen (141) und Datenleitungen (31), wobei die Datenleitungen (31) in Draufsicht die Wortleitungen (30) schneiden, dadurch gekennzeichnet,

daß der Festspeicher Zellen aufweist mit einer ersten und einer zweiten Metallschicht, wobei die erste Metallschicht dem Substrat näher als die zweite Metallschicht ist,

daß die Masseleitungen einen ersten und einen zweiten Teil aufweisen, wobei der erste Teil ein Halbleiter-Störstellenbereich (14) ist, der im wesentlichen parallel zu den Wortleitungen (30) verläuft, und der zweite Teil Metall der ersten Metallschicht aufweist und im wesentlichen parallel zu den Datenleitungen verläuft, und

daß die zweite Metallschicht (33) über den Wortleitungen (30) durch einen Isolator (23, 16) vorgesehen ist und mit den Wortleitungen (30) elektrisch verbunden ist.

3. Speicher nach Anspruch 1 oder 2, bei welchem die Wortleitungen (9, 30) und die Datenleitungen (11, 31) im wesentlichen senkrecht verlaufen.

4. Speicher nach einem der Ansprüche 1 bis 3, bei welchem die Masseleitungen (10, 311, 141) abwechselnd in Lücken zwischen den Wortleitungen (9) vorgesehen sind.

5. Speicher nach einem der vorhergehenden Ansprüche mit abwechselnd ersten und zweiten Störstellenbereichen (14, 141) in dem Halbleitersubstrat, wobei die Datenleitungen (11) mit den ersten Störstellenbereichen (14) verbunden und die Masseleitungen (10) mit den zweiten Störstellenbereichen (141) verbunden sind.

6. Speicher nach Anspruch 5, bei welchem die zweiten Störstellenbereiche (141) parallel zu den Wortleitungen (9) verlaufen.

7. Speicher nach Anspruch 5 oder 6, bei welchem die ersten Störstellenschichten (14) und die Datenleitungen (11) durch Anschlußflächen einer Metallschicht miteinander verbunden sind, wobei die Metallschicht auch die Masseleitungen (10) aufweist.

8. Speicher nach Anspruch 5 oder 6, bei welchem die ersten Störstellenschichten (14) und die Datenleitungen (11) direkt miteinander verbunden sind.

9. Speicher nach einem der Ansprüche 1 bis 4, mit abwechselnd in dem Halbleitersubstrat angeordneten ersten und zweiten Störstellenbereichen (14, 141), wobei die Datenleitungen mit den ersten Störstellenbereichen (14) verbunden sind, und wobei die Masseleitungen von den zweiten Störstellenbereichen (141) gebildet sind.

10. Speicher nach einem oder vorhergehenden Ansprüche, der außerdem Metall-Leitungen (33) aufweist, die durch einen Isolator von den Wortleitungen (30) getrennt sind, mit Ausnahme von zwei oder mehr Punkten, an denen die Metall-Leitungen (33) und die Wortleitungen (30) miteinander verbunden sind.

11. Speicher nach Anspruch 10, bei welchem die Wortleitungen (30) und die Metall-Leitungen (33) durch weitere Metall-Leitungen (312) miteinander verbunden sind, wobei die weiteren Metall-Leitungen (312) Teil der gleichen Metallschicht wie die Datenleitungen (31) sind.

12. Mikrocomputer, der einen Festspeicher nach einem der vorhergehenden Ansprüche verwendet.

**Revendications**

1. Mémoire figée à semiconducteurs utilisant des transistors à effet de champ à grille isolée (31), comportant des lignes de transmission de mots (9) s'étendant linéairement au-dessus d'un substrat semiconducteur, des lignes de masse (10) et des lignes de transmission de données (11), les lignes de transmission de données (11) entrecoupant, en vue en plan, les lignes de transmission, de mots (9);

dans laquelle les lignes de masse (10) sont sensiblement parallèles aux lignes de transmission de mots, caractérisée en ce que la mémoire figée possède des cellules comprenant une première et une seconde couches métalliques, la première couche métallique étant plus proche du substrat que la seconde couche métallique; en ce que les lignes de masse (10) comportent du métal de la première couche métallique, et en ce que les lignes de transmission de donées (11) comportent du métal de la seconde couche métallique.

2. Mémoire figée à semiconducteurs utilisant des transistors à effet de champ à grille isolée (31), comportant des lignes de transmission de mots (30) s'étendant linéairement au-dessus d'un substrat semiconducteur, des lignes de masse (141) et des lignes de transmission de données (31), les lignes de transmission de données (31) entrecoupant, en vue en plan, les lignes de transmission de mots (30); caractérisée en ce que

la mémoire figée possède des cellules comprenant une première et une second couches métalliques, la première couche métallique étant plus proche du substrat que la seconde couche métallique;

les lignes de masse comportent une première partie et une seconde partie, la première partie étant une région d'impuretés semiconductrice (141) s'étendant sensiblement parallèlement aux lignes de transmission de mots (30), et la seconde partie comportant du métal de la première couche métallique et s'étendant sensiblement parallèlement aux lignes de transmission de données, et en ce que la seconde couche métallique (33) est prévue au dessus des lignes de transmission de mots (30) avec interposition d'un isolateur (23, 16) et reliée électriquement aux lignes de transmission de mots (30).

3. Mémoire selon la revendication 1 ou la revendication 2, dans laquelle les lignes de transmission de mots (9, 30) et les lignes de transmission de données (11, 31) sont sensiblement perpendiculaires.

4. Mémoire selon l'une quelconque des revendications 1 à 3, dans laquelle les lignes de masse (10, 311, 141) sont prévues dans des intervalles alternés entre les lignes de transmission de mots (9).

5. Mémoire selon l'une quelconque des revendications précédentes, possédant des première et seconde régions d'impuretés (14, 141) en alternance dans le substrat semiconducteur, les lignes de transmission de données (11) étant reliées aux premières régions d'impuretés (14) et les lignes de masse (10) étant reliées aux secondes régions d'impuretés (141).

6. Mémoire selon la revendication 5, dans laquelle les régions d'impuretés (141) sont parallèles aux lignes de transmission de mots (9).

7. Mémoire selon la revendication 5 ou la revendication 6, dans laquelle les premières couches d'impuretés (14) et les lignes de transmission de données (11) sont reliées entre elles par des plots d'une couche métallique, la couche métallique comprenant également les lignes de masse (10).

8. Mémoire selon la revendication 5 ou la revendication 6, dans laquelle les premières couches d'impuretés (14) et les lignes de transmission de données (11) sont directement reliées entre elles.

9. Mémoire selon l'une quelconque des revendications 1 à 4, possédant des premières et des secondes régions d'impuretés (14, 141) en alternance dans le substrat semiconducteur, les lignes de transmission de données étant reliées aux premières régions d'impuretés (14), les lignes de masse étant formées par les secondes régions d'impuretés (141).

10. Mémoire selon l'une quelconque des revendications précédentes, comprenant en outre des lignes métalliques (33) séparées des lignes de transmission de mots (30) par un isolateur sauf en deux ou plusieurs points, points auxquels les lignes métalliques (33) et les lignes de transmission de mots (30) sont reliées entre elles.

11. Mémoire selon la revendication 10, dans laquelle les lignes de transmission (30) et les lignes métalliques (33) sont reliées entre elles par d'autres lignes métalliques (312), les autres lignes métalliques (312) faisant partie de la même couche métallique que les lignes de transmission de données (31).

12. Microcalculateur utilisant une mémoire figée selon l'une quelconque des revendications précédentes.

## FIG. 1 PRIOR ART

## FIG. 2 PRIOR ART

## FIG. 3 PRIOR ART

## FIG. 4

## FIG. 5

11  10  15  16        24  13  15  16  10

15 ―                                    ― 15

n⁺          n⁺          n⁺

23  141  9  25  14  9  141  23

231        231

## FIG. 6

25(23)            14(141)

17

9

141(14)

23(25)

## FIG. 7

25(23)            14(141)

19

9

141(14)

23(25)

3

# FIG. 8

4

## FIG. 9

## FIG. 10

## FIG. 11

5